# EUROPEAN PATENT SPECIFICATION

(11) **EP 2 824 275 B1**
(45) Date of publication and mention of the grant of the patent: **16.09.2015**
(21) Application number: 13175644.7
(22) Date of filing: 09.07.2013
(51) Int. Cl.: E21B 33/035, E21B 41/00, H05K 7/20

(54) **Subsea unit with cooling of electronic devices**
Unterwassereinheit mit Kühlung von elektronischen Vorrichtungen
Unité sous-marine avec refroidissement de dispositifs électroniques

(43) Date of publication of application: 14.01.2015
(73) Proprietor: ABB Technology Ltd, 8050 Zürich (CH)
(72) Inventor: Spindler, Christian, 8707 Uetikon am See (CH); Bolgiani, Fabio, CH-5242 Lupfig (CH); Midtun, Paul, NO-5099 Bergen (NO); Rongve, Knut, 5144 Fyllingsdalen (NO); Ronhovd, Tor-Odd, 5108 Hordvik (NO)
(74) Representative: Savela, Reino Aleksi

(56) References cited:
- EP-A1- 2 467 005
- EP-A1- 2 487 327
- WO-A1-01/13692
- US-A- 6 134 892
- US-A1- 2008 302 115

## Description

### TECHNICAL FIELD

The present disclosure generally relates to subsea installations and in particular to a subsea unit arranged to cool electronic devices contained therein.

### BACKGROUND

In recent years, there has been a growing interest in installing electrical installations on the sea floor in depths from a few tens of meters to even kilometres. Oil and gas production subsea employs electric equipment like drilling motors, pumps, and compressors driven by frequency converters.

In bringing power electronics subsea, two general concepts exist: (1) the equipment stays at or near atmospheric pressure in a pressure vessel; and (2) the equipment is pressurized to the hydrostatic pressure level on sea ground. The two concepts can be differentiated as follows. Concept (1) has the advantage that standard electric/electronic components, known from onshore installations, can be used, while disadvantages include thick walls needed for the enclosure to withstand the pressure difference between inside and outside. Thick walls make the equipment heavy and costly. Concept (2) has the advantage that no thick walls are needed for the enclosure since the pressure difference between inside and outside the containment is much less than for concept (1). Disadvantages of concept (2) are that all the components must be free of gas inclusions and compressible voids; otherwise they implode during pressurization and are destroyed.

Cooling systems are essential in power electronic devices to transfer the heat generated by the power semiconductors. Frequency converters in the medium voltage and power range drive electric motors by controlling the speed and torque of these machines and are a well proven equipment in the entire onshore and offshore platform based industry.

WO 2008/004885 discloses a lightweight underwater cooling assembly connected to a pressure vessel and comprises a refrigerant boiling chamber in which heat exchanger tubes are provided. The cooling assembly may be part of an underwater gas and/or oil production assembly and may be configured to cool underwater equipment such as one or more electrical motors and/or gas compressors. The cooling assembly has a thin-walled water cooled condenser and a thin-walled pressure compensating membrane which maintains the fluid pressure within the boiling chamber and condenser substantially similar to the fluid pressure of the sea water surrounding the submerged refrigerant boiling chamber. The heat exchanger tubes and the pressure vessel are adapted to withstand the internal operational pressure as well as the external seawater pressure.

EP2487327 discloses a subsea electronic system which is of the type which has a passive pressure compensator and comprises an electronic component such as a power electronics device. The device is submerged or partially submerged in a dielectric liquid. The subsea electronic system may further comprise a support structure by means of which the electronic component is supported on a wall of the enclosure.

### SUMMARY

The present disclosure aims at providing an alternative manner of providing passive cooling of electronic devices in a subsea unit, utilising existing subsea unit structures for cooling purposes. A simplified subsea unit construction and more robust cooling may thereby be provided. A general object of the present disclosure is hence to provide simplified passive cooling of one or more electronic devices in a subsea unit.

Hence, according to a first aspect of the present disclosure there is provided a subsea unit comprising: an external housing; a passive pressure compensator arranged to reduce a pressure difference between ambient subsea pressure and pressure inside the external housing; a dielectric liquid for counteracting deformation of the external housing; an electronic device; and an electrical insulator which is thermally conductive and arranged between an internal surface of the external housing and the electronic device, wherein the electronic device is in thermal and electrical connection with the electrical insulator, and wherein the electrical insulator is arranged to transfer heat from the electronic device to the external housing.

An effect which may be obtainable thereby is simple, efficient and highly robust and reliable cooling of the electronic device, ensuring reliable

operation of the electronic device. The cooling is especially efficient due to the relative thinness of the external housing compared to the housing wall thickness of pressure vessels.

A passive pressure compensator is to be construed as a pressure compensator that does not rely on active control for achieving pressure compensation or equalisation. The pressure that is applied to the passive pressure compensator influences the passive pressure compensator such that pressure compensation may be obtained.

One embodiment comprises a tension member arranged to apply pressure to the electronic device towards the external housing to maintain a fixed position of the electronic device relative to the external housing. The electronic device may thereby be fixed to the external housing allowing reliable cooling of the electronic device even if the subsea unit is moved subsea.

One embodiment comprises a pressure distributor arranged between the electronic device and the tension member to distribute the pressure applied to the electronic device by the tension member. Thereby, the entire heat emitting surface of the electronic device may be pressed towards the internal surface of the external housing enhancing the cooling effect of the electronic device.

According to one embodiment the pressure distributor has an end face which faces the electronic device, wherein the end face has a dimension corresponding essentially to a dimension of that end of the electronic device which faces the pressure distributor. The pressure applied by the tension member can thereby be distributed evenly across the electronic device.

According to one embodiment the pressure distributor is adapted to electrically insulate the electronic device from the tension member. In case the tension member is made of an electrically conducting material, which typically have a higher mechanical strength than electrically insulating materials, the pressure distributor electrically insulates the electronic device from the tension member.

One embodiment comprises fasteners arranged to fasten the tension member to the external housing. The fasteners may fixate the tension member in a manner in which the tension member can provide the necessary pressure to the pressure distributor and thus to the electronic device.

According to one embodiment the fasteners are arranged in such a manner relative to the electronic device that pressure applied by the tension member is evenly distributed to the electronic device.

According to one embodiment the fasteners are arc-mounted bolts. By utilising arc-mounting to fasten the tension member, the external housing may be weakened in a minimal manner.

According to one embodiment the electronic device is a power electronic device.

According to one embodiment the electrical insulator is attached to the internal surface of the external housing.

One embodiment comprises a plurality of electronic devices, a plurality of electrical insulators, a plurality of tension members and a plurality of pressure distributors, wherein each electronic device is associated with a respective electrical insulator, tension member and pressure distributor. A plurality of electronic devices may for example form part of a power converter or a frequency converter arranged to drive subsea machinery. Such converters include a plurality of electronic devices generating a large amount of heat. By means of the relatively thin walls of the subsea unit which is pressurised to the ambient hydrostatic pressure level, sufficient cooling may be provided to cool an electronic device assembly which comprises a plurality of electronic devices.

According to one embodiment the plurality of electronic devices are arranged in a grid pattern and the plurality of tension members form a tension arrangement.

According to one embodiment the plurality of electronic devices form part of a power converter or a frequency converter.

The subsea unit according to the first aspect may beneficially be utilised in a subsea power provision system. Such a subsea power provision system may be a power transmission system or a power distribution system.

Generally, all terms used in the claims are to be interpreted according to their ordinary meaning in the technical field, unless explicitly defined otherwise herein. All references to "a/an/the element, apparatus, component, means, etc. are to be interpreted openly as referring to at least one instance of the element, apparatus, component, means, etc., unless explicitly stated otherwise.

### BRIEF DESCRIPTION OF THE DRAWINGS

The specific embodiments of the inventive concept will now be described, by way of example, with reference to the accompanying drawings, in which:
Fig. 1 is side view, with the external housing on the side cut-away, of a subsea unit;
Fig. 2a depicts a side view of an electronic device arranged at the external housing of a subsea unit;
Fig. 2b is a top view of the electronic device in Fig. 2a;
Fig. 3a shows a side view of an example of an electronic device assembly arranged at the external housing of a subsea unit;
Fig. 3b is a top view of the electronic device assembly in Fig. 3a; and
Fig. 3c is a top view of another example of an electronic device assembly.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

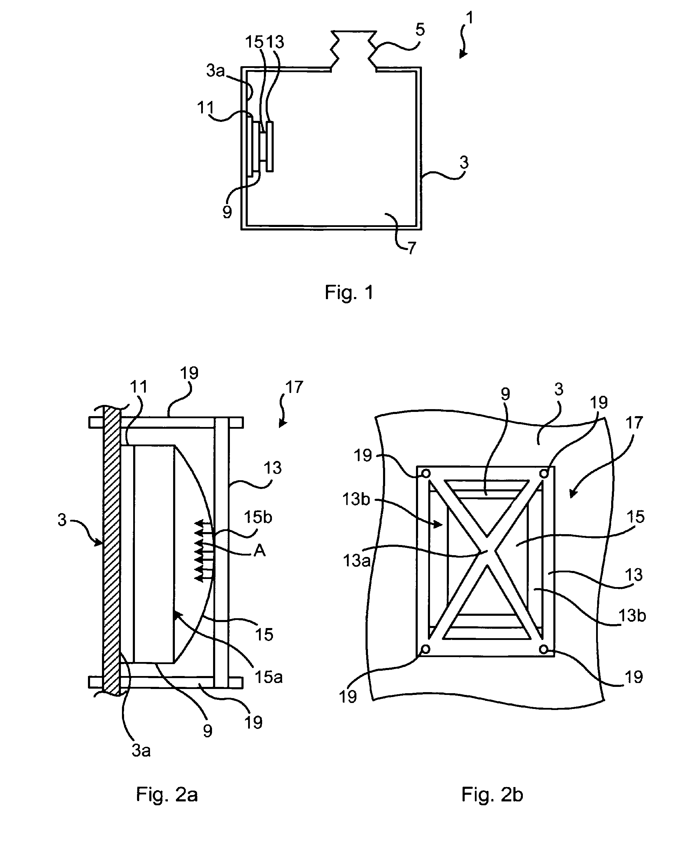

Fig. 1 schematically depicts a side view, with the external housing on the side cut-away, of a subsea unit for installation on the seabed. Subsea unit 1 has an external housing 3, and comprises a passive pressure compensator 5, a dielectric liquid 7 and an electronic device 9. The external housing is made of a material which has high thermal conductivity, preferably metal such as steel e.g. stainless steel. The dielectric liquid 7 fills the entire interior space of the subsea unit 1 so as to prevent the occurrence of any air gaps between the internal surface of the external housing 3 and any internal component, such as electronic device 9, contained in the subsea unit 9. The dielectric liquid 7 counteracts deformation of the external housing 3 when the subsea unit 1 is subjected to an ambient subsea pressure higher than a pressure that the external housing 3 can withstand without deformation. The dielectric liquid 7 may for example be oil or an ester, and prevents short circuit of any electronic or electric device contained in the subsea unit 1.

The passive pressure compensator 5 is arranged to transmit ambient subsea pressure to the inside of the external housing 3. Thereby a pressure difference between ambient subsea pressure and pressure inside the external housing 3 may be reduced. The passive pressure compensator 5 may for example be defined by a mechanically flexible portion of the external housing 3, or a membrane such as an impermeable membrane. The interior volume of the subsea unit 1 and thus the pressure inside the external housing 3 is hence dependent of the ambient subsea pressure.

The electronic device 9 is adapted to withstand the high pressures present at depths at which the subsea unit 1 is to be installed. Such devices are know in the art, and will therefore not be elaborated any further herein. Examples of electronic devices are capacitors, for example capacitors based on metalized film technology or on oil-soaked film-foil technology, and power electronic devices such as insulated gate bipolar transistor (IGBT) modules, integrated gate-commutated thyristors (IGCT), diodes, and thyristors.

The electronic device 9 is arranged to be directly cooled by the external housing 3, which when installed at the seabed is subjected to cool water temperatures. Direct cooling of the electronic device 9 is achieved by arranging the electronic device 9 in thermal communication with the external housing 3.

The electronic device 9 may have a different electric potential than the electric potential of the external housing 3. The electronic device 9 may for example not be provided with an electrically insulating enclosure, since such an enclosure would either have to be a pressure vessel in which atmospheric pressure is maintained, or it would have to be provided with its own pressure compensator. Hence, the electronic device 9 may have an electric potential which differs from ground potential, which is typically the electric potential of the external housing.

In order to electrically insulate the electronic device 9 from the external surface 3 the subsea unit 1 comprises an electrical insulator 11 arranged between an internal surface 3a of the external housing 3 and the electronic device 9. The electrical insulator 11 may be fixed to the external housing 3. The electrical insulator 11 may thus have a surface in direct thermal communication with the external housing 3. The electronic device 9 may be attached to, and in physical contact with, the electrical insulator 11

The electrical insulator 11 is thermally conductive such that heat emitted by the electronic device 9 may be transferred to the external housing 3. Efficient passive cooling of the electronic device 9 may thereby be obtained by means of a simple mechanical construction. The electrical insulator 11 may comprise any material or compound having suitable electrical insulating and thermally conductive properties. The electrical insulator 11 may for example comprise ceramic and/or aluminium oxide. Aluminium oxide for example may have a dielectric strength of 16.9 kV/mm and thermal conductivity of 35 W/mK.

According to one variation, the subsea unit 1 comprises a tension member 13 arranged to apply pressure to the electronic device 9 towards the external housing. A fixed position of the electronic device 9 can thereby be maintained relative to the external housing 3. Furthermore, a pressure distributor 15 may be arranged between the electronic device 9 and the tension member 13 to distribute the pressure applied to the electronic device 9 by the tension member 13. In case the tension member 13 is made of electrically conductive material, the pressure distributor 15 is an electrical insulator adapted to electrically insulate the electronic device 9 from the tension member 13.

Fig. 2a depicts a side view of an example of an arrangement 17 for mechanically fixating an electronic device 9 to the external housing 3 of subsea unit 1. The electronic device 9 is sandwiched between the electrical insulator 11 and the pressure distributor 15. The pressure distributor 15 has an end face 15a which faces the electronic device 9 and an opposite end face 15b facing the tension member 13. According to the example, the end face 15a which faces the electronic device 9 has a dimension corresponding essentially to a dimension of that end 9a of the electronic device 9 which faces the pressure distributor 15. The opposite end 15b of the pressure distributor 15, i.e. the end facing the tension member 13, is subjected to a force applied thereto by the tension member 13, as indicated by the arrows A. The tension member 13 may abut the pressure distributor 15 to thereby apply force or pressure to the pressure distributor 15. In particular, the tension member 13 and the pressure distributor 15 are arranged relative to each other in such a manner that the pressure distributor 15 is subjected to an evenly distributed pressure. By this design, the force applied to the pressure distributor 15 is transferred and distributed evenly to the electronic device 9. The electronic device 9 in turn applies a force to the electrical insulator 11 which is in direct thermal communication with the external housing 3.

According to one variation, essentially the entire surface of the electronic device 9, which emits heat and faces the external housing 3 is in direct thermal connection with the electrical insulator 11. Heat emitted from this surface may thus efficiently be transmitted to the external housing 3 through the electrical insulator 11.

The exemplified subsea unit 1 comprises fasteners 19 arranged to fasten the tension member 19 to the external housing 3 such that the tension member is enabled to apply a force to the pressure distributor 15 and thus to the electronic device 9, to fixate the electronic device 9 to the external housing 3. The fasteners 19 are arranged such that the tension member 13 can exert an even pressure to the pressure distributor 15. A respective fastener may for example be arranged at each corner of the electronic device if the electronic device is rectangular or essentially rectangular. In case the electronic device is elliptical, the four fasteners may be arranged in a rectangular pattern around the electrical device, or three fasteners may be arranged with each adjacent pair of fasteners at 120°angle around the electrical device, for example. It should be noted that other electronic device shapes could also be utilised.

The fasteners may for example be arc-mounted bolts. Arc-mounted bolts which are welded to the external housing weaken the external housing 3 minimally, as unnecessary penetration into the external housing may be omitted.

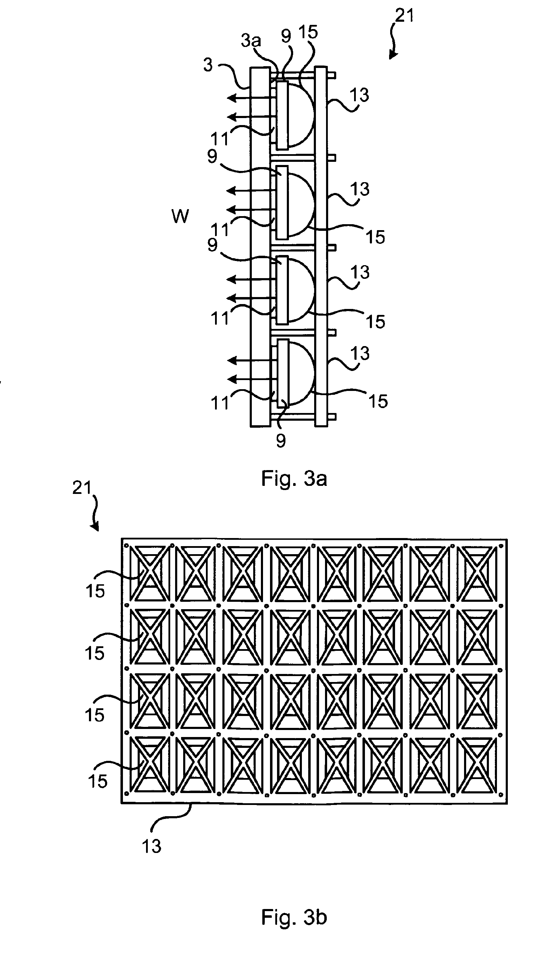

Fig. 2b shows a top view of the arrangement 17. According to the example, the tension member 13 has openings 13b which allow dielectric fluid 7 to flow therethrough to provide cooling by means of for example natural convection of the dielectric fluid 7, in addition to the direct cooling provided by means of the external housing 3.One realisation of the openings 13b is shown in the example in Fig. 3b in which the tension member 13 has a frame and a pressure exerting portion 13a, which is X-shaped. Dielectric fluid 7 is thus able to flow between the legs of the pressure exerting portion 13a. It should be noted that other tension member shapes are also possible and that the one described above merely constitutes one example.

Advantageously, the arrangement 17 and its variations presented herein enable the creation of an electronic device assembly 21. Such an electronic device assembly 21 is shown in Fig. 3a. A plurality of electronic devices 9 are arranged to form an electronic device assembly, which electronic devices 9 together may form part of for example a power converter or a frequency converter. The electronic devices 9 may for example be arranged in rows and columns to form a grid pattern, as shown in Fig. 3b. Each electronic device 9 is associated with an electrical insulator 11, a pressure distributor 15 and a tension member 13, as described above with reference to Figs 1-2b. Each electronic device 9 is thus directly cooled by water w via the external housing 3 through an electrical insulator 11, as illustrated by the arrows in Fig. 3b. The entire electronic device assembly 21 may hence be fixed to the internal surface 3a of the external housing 3. In particular, this grid formation with a plurality of electronic devices in close proximity, generating a large amount of heat, may be realised due to the efficient cooling through the relatively thin external housing 3 of subsea unit 1 which is adapted to be pressurised to ambient subsea pressure.

Fig. 3b further illustrates the electronic device assembly 21 as seen in a top view perspective. To further simplify the construction of the electronic device assembly 21, the tension members 13 may form a single piece tension arrangement arranged to provide pressure to each pressure distributor 15 and thus each electronic device 9 by means of a respective tension member 13. The tension members 15 are mechanically coupled forming the integral single piece tension arrangement. Such a tension arrangement may be provided with a plurality of openings, for example one for each electronic device, to allow dielectric fluid to flow through the single piece tension arrangement for additional cooling of the electronic devices 9. A tension arrangement provides a simplified assembly of the electronic device assembly 21.

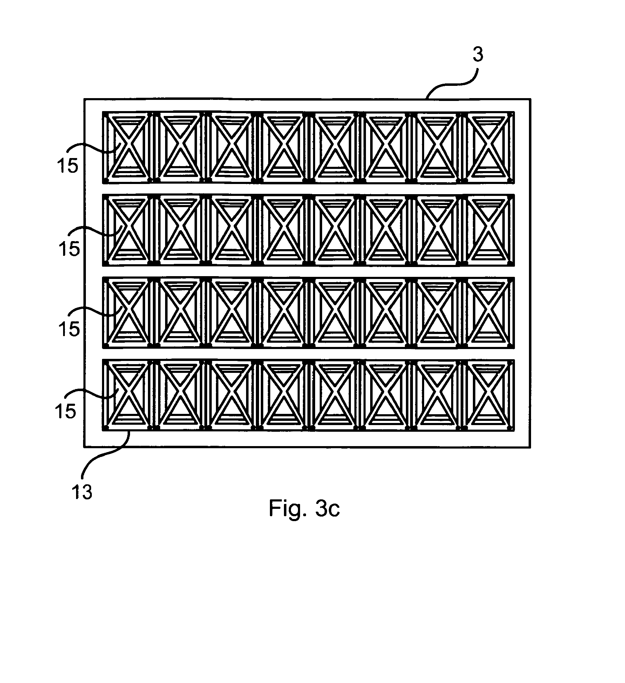

Fig. 3c depicts another example of an electronic device assembly. Also according to this example, a plurality of electronic devices are arranged to form the electronic device assembly. Instead of an integral single piece tension arrangement as in the previous example, the exemplified electronic device assembly comprises a plurality of individual tension members 13, each individual tension member 13 being arranged to provide pressure, via a respective pressure distributor, to a respective electronic device.

It is envisaged that the subsea unit presented herein finds applications within the oil and gas industry for example for subsea HVDC/HVAC power provision systems, i.e. power transmission and power distribution systems, as well as offshore power generation such as wind energy, tidal energy, wave energy, and ocean current energy.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. A subsea unit (1) comprising:
an external housing (3),
a passive pressure compensator (5) arranged to reduce a pressure difference between ambient subsea pressure and pressure inside the external housing (3),
a dielectric liquid (7) for counteracting deformation of the external housing (3),
an electronic device (9),
a tension member (13) arranged to apply pressure to the electronic device (9) towards the external housing (3) to maintain a fixed position of the electronic device (9) relative to the external housing (3), and
an electrical insulator (11) which is thermally conductive and arranged between an internal surface (3a) of the external housing (3) and the electronic device (9), wherein the electrical insulator (11) is attached to the internal surface (3a) of the external housing (3), and wherein the electronic device (9) is in thermal and electrical connection with the electrical insulator (11), and wherein the electrical insulator (11) is arranged to transfer heat from the electronic device (9) to the external housing (3) for cooling of the electronic device (9).

2. The subsea unit (1) as claimed in claim 1, comprising a pressure distributor (15) arranged between the electronic device (9) and the tension member (13) to distribute the pressure applied to the electronic device (9) by the tension member (13).

3. The subsea unit (1) as claimed in claim 2, wherein the pressure distributor (15) has an end face (15a) which faces the electronic device (9), wherein the end face (15a) has a dimension corresponding essentially to a dimension of that end of the electronic device (9) which faces the pressure distributor (15).

4. The subsea unit (1) as claimed in claim 2 or 3, wherein the pressure distributor (15) is adapted to electrically insulate the electronic device (9) from the tension member (13).

5. The subsea unit (1) as claimed in claim any of claims 1-4, comprising fasteners (19) arranged to fasten the tension member (13) to the external housing (3).

6. The subsea unit (1) as claimed in claim 5, wherein the fasteners (19) are arranged in such a manner relative to the electronic device (9) that pressure applied by the tension member (13) is evenly distributed to the electronic device (9).

7. The subsea unit (1) as claimed in any of the preceding claims, wherein the electronic device (9) is a power electronic device.

8. The subsea unit (1) as claimed in any of claims 2-7, comprising a plurality of electronic devices (9), a plurality of electrical insulators (11), a plurality of tension members (13) and a plurality of pressure distributors (15), wherein each electronic device (9) is associated with a respective electrical insulator (11), tension member (13) and pressure distributor (15).

9. The subsea unit (1) as claimed in claim 8, wherein the plurality of electronic devices (9) are arranged in a grid pattern and the plurality of tension members (13) form a tension arrangement.

10. The subsea unit (1) as claimed in claim 8 or 9, wherein the plurality of electronic devices (9) form part of a power converter or frequency converter.

11. A subsea power provision system comprising a subsea unit (1) as claimed in any of claims 1-10.

12. The subsea power provision system as claimed in claim 11, wherein the subsea power provision system is a power transmission system or a power distribution system.

## Patentansprüche

1. Unterwassereinheit (1), aufweisend:
ein äußeres Gehäuse (3),
einen passiven Druckausgleicher (5), der ausgeführt ist, um eine Druckdifferenz zwischen dem umgebenden Unterwasserdruck und dem Druck innerhalb des äußeren Gehäuses (3) zu reduzieren,
eine Isolierflüssigkeit (7), um einer Deformation des äußeren Gehäuses (3) entgegenzuwirken,
ein elektronisches Gerät (9),
ein Zugglied (13), das ausgeführt ist, Druck auf das elektronische Gerät (9) in Richtung auf das äußere Gehäuse (3) auszuüben, um eine feste Position des elektronischen Gerätes (9) relativ zum äußeren Gehäuse (3) aufrechtzuerhalten, und
einen elektrischen Isolator (11), der thermisch leitend und zwischen einer Innenfläche (3a) des äußeren Gehäuses (3) und dem elektronischen Gerät (9) angeordnet ist, wobei der elektrische Isolator (11) an der Innenfläche (3a) des äußeren Gehäuses (3) befestigt ist, und wobei das elektronische Gerät (9) in thermischer und elektrischer Verbindung mit dem elektrischen Isolator (11) steht, und wobei der elektrische Isolator (11) ausgeführt ist, Wärme von dem elektronischen Gerät (9) auf das äußere Gehäuse (3) zu übertragen, um das elektronische Gerät (9) zu kühlen.

2. Unterwassereinheit (1) nach Anspruch 1, aufweisend einen Druckverteiler (15), der zwischen dem elektronischen Gerät (9) und dem Zugglied (13) angeordnet ist, um den Druck zu verteilen, der auf das elektronische Gerät (9) durch das Zugglied (13) ausgeübt wird.

3. Unterwassereinheit (1) nach Anspruch 2, wobei der Druckverteiler (15) eine Endfläche (15a) aufweist, welche dem elektronischen Gerät (9) gegenübersteht, wobei die Endfläche (15a) eine Dimension aufweist, die im Wesentlichen einer Dimension dieses Endes des elektronischen Gerätes (9) entspricht, welches dem Druckverteiler (15) gegenübersteht.

4. Unterwassereinheit (1) nach Anspruch 2 oder 3, wobei der Druckverteiler (15) angepasst ist, das elektronische Gerät (9) von dem Zugglied (13) elektrisch zu isolieren.

5. Unterwassereinheit (1) nach irgendeinem der Ansprüche 1 bis 4, aufweisend Befestigungselemente (19), die derart angeordnet sind, dass sie das Zugglied (13) am äußeren Gehäuse (3) befestigen.

6. Unterwassereinheit (1) nach Anspruch 5, wobei die Befestigungselemente (19) auf solche Art und Weise relativ zu dem elektronischen Gerät (9) angeordnet sind, dass der Druck, der von dem Zugglied (13) ausgeübt wird, gleichmäßig auf das elektronische Gerät (9) verteilt wird.

7. Unterwassereinheit (1) nach irgendeinem der vorstehenden Ansprüche, wobei das elektronische Gerät (9) ein Leistungselektronikgerät ist.

8. Unterwassereinheit (1) nach irgendeinem der Ansprüche 2 bis 7, aufweisend mehrere elektronische Geräte (9), mehrere elektrische Isolatoren (11), mehrere Zugglieder (13) und mehrere Druckverteiler (15), wobei jedes elektronische Gerät (9) mit einem entsprechenden elektrischen Isolator (11), Zugglied (13) und Druckverteiler (15) verbunden ist.

9. Unterwassereinheit (1) nach Anspruch 8, wobei die mehreren elektronischen Geräte (9) in einem Gittermuster angeordnet sind und die mehreren Zugglieder (13) eine Zuganordnung bilden.

10. Unterwassereinheit (1) nach Anspruch 8 oder 9, wobei die mehreren elektronischen Geräte (9) einen Teil eines Stromrichters oder Frequenzumrichters bilden.

11. Unterwasserstromversorgungssystem, aufweisend eine Unterwassereinheit (1) nach irgendeinem der Ansprüche 1 bis 10.

12. Unterwasserstromversorgungssystem nach Anspruch 11, wobei das Unterwasserstromversorgungssystem ein Stromübertragungssystem oder ein Stromverteilungssystem ist.

## Revendications

1. Unité sous-marine (1) comprenant :
un boîtier externe (3),
un compensateur de pression passif (5) agencé pour réduire une différence de pression entre la pression sous-marine ambiante et la pression à l'intérieur du boîtier externe (3),
un liquide diélectrique (7) destiné à s'opposer à la déformation du boîtier externe (3),
un dispositif électronique (9),
un élément de tension (13) agencé pour appliquer une pression sur le dispositif électronique (9) en direction du boîtier externe (3) afin de maintenir une position fixe du dispositif électronique (9) par rapport au boîtier externe (3), et
un isolateur électrique (11) thermiquement conducteur et agencé entre une surface interne (3a) du boîtier externe (3) et le dispositif électronique (9), l'isolateur électrique (11) étant attaché à la surface interne (3a) du boîtier externe (3), et le dispositif électronique (9) étant en liaison thermique et électrique avec l'isolateur électrique (11), et l'isolateur électrique (11) étant agencé pour transférer la chaleur émanant du dispositif électronique (9) vers le boîtier externe (3) afin de refroidir le dispositif électronique (9).

2. Unité sous-marine (1) selon la revendication 1, comprenant un répartiteur de pression (15) agencé entre le dispositif électronique (9) et l'élément de tension (13) pour répartir la pression appliquée sur le dispositif électronique (9) par l'élément de tension (13).

3. Unité sous-marine (1) selon la revendication 2, dans laquelle le répartiteur de pression (15) possède une face d'extrémité (15a) placée en regard du dispositif électronique (9), la face d'extrémité (15a) présentant une dimension correspondant essentiellement à une dimension de l'extrémité du dispositif électronique (9) qui est en regard du répartiteur de pression (15).

4. Unité sous-marine (1) selon la revendication 2 ou 3, dans laquelle le répartiteur de pression (15) est adapté à isoler électriquement le dispositif électronique (9) de l'élément de tension (13).

5. Unité sous-marine (1) selon l'une quelconque des revendications 1 à 4, comprenant des fixations (19) agencées pour fixer l'élément de tension (13) au boîtier externe (3).

6. Unité sous-marine (1) selon la revendication 5, dans laquelle les fixations (19) sont agencées relativement au dispositif électronique (9) de manière à ce que la pression appliquée par l'élément de tension (13) soit uniformément répartie sur le dispositif électronique (9).

7. Unité sous-marine (1) selon l'une quelconque des revendications précédentes, dans laquelle le dispositif électronique (9) est un dispositif électronique de puissance.

8. Unité sous-marine (1) selon l'une quelconque des revendications 2 à 7, comprenant une pluralité de dispositifs électroniques (9), une pluralité d'isolateurs électriques (11), une pluralité d'éléments de tension (13) et une pluralité de répartiteurs de pression (15), chaque dispositif électronique (9) étant associé à des isolateur électrique (11), élément de tension (13) et répartiteur de pression (15) respectifs.

9. Unité sous-marine (1) selon la revendication 8, dans laquelle la pluralité de dispositifs électroniques (9) sont agencés selon un schéma en grille et la pluralité d'éléments de tension (13) forment un agencement de tension.

10. Unité sous-marine (1) selon la revendication 8 ou 9, dans laquelle la pluralité de dispositifs électroniques (9) font partie d'un convertisseur de puissance ou d'un convertisseur de fréquence.

11. Système d'approvisionnement en énergie sous-marin comprenant une unité sous-marine (1) selon l'une quelconque des revendications 1 à 10.

12. Système d'approvisionnement en énergie sous-marin selon la revendication 11, lequel système d'approvisionnement en énergie sous-marin est un système de transport d'énergie ou un système de distribution d'énergie.
